Europäisches Patentamt

(19) European Patent Office

Office européen des brevets

(11) Numéro de publication: **0 130 923**
**B1**

(12) # FASCICULE DE BREVET EUROPEEN

(45) Date de publication du fascicule du brevet:
16.09.87

(51) Int. Cl.⁴: **H 01 R 4/68, H 01 L 39/02**

(21) Numéro de dépôt: **84401417.5**

(22) Date de dépôt: **04.07.84**

(54) **Procédé pour réaliser une connexion entre fils supraconducteurs.**

(30) Priorité: **05.07.83 FR 8311147**

(43) Date de publication de la demande:
**09.01.85 Bulletin 85/2**

(45) Mention de la délivrance du brevet:
**16.09.87 Bulletin 87/38**

(84) Etats contractants désignés:
**CH DE GB LI NL SE**

(56) Documents cités:
**WO - A - 80/02084
FR - A - 1 585 965
GB - A - 1 073 207
GB - A - 1 298 068
US - A - 3 422 529**

**PROCEEDINGS OF THE SIXTH SYMPOSIUM ON
ENGINEERING PROBLEMS OF FUSION RESEARCH,
18-21 novembre 1975, San Diego, Cal., pages 106-110,
IEEE, New York, US; D.N. CORNISH et al.: "Explosive
joints in Nb-Ti/Cu composite superconductors"**

(73) Titulaire: **Etablissement Public dit: CENTRE NATIONAL
DE LA RECHERCHE SCIENTIFIQUE (CNRS), 15, Quai
Anatole France, F-75007 Paris (FR)**

(72) Inventeur: **Chaussy, Jacques, 20, Allée François Villon,
F-38130 Echirolles (FR)**
Inventeur: **Genicon, Jean-Louis, Cédex 258 Crolles,
F-38190 Brigoud (FR)**
Inventeur: **Mazuer, Jean, 460, avenue de Stalingrad,
F-38340 Voreppe (FR)**
Inventeur: **Pilon, Jean, 18, rue Marcel Peretto,
F-38000 Grenoble (FR)**
Inventeur: **Sulpice, André, F-73470 Novalaise (FR)**

(74) Mandataire: **Bruder, Michel, 10 rue de la Pépinière,
F-75008 Paris (FR)**

# Description

La présente invention concerne un procédé pour réaliser une connexion entre fils supraconducteurs.

Lorsqu'on réalise un circuit supraconducteur dont la caractéristique principale est d'avoir une résistance électrique nulle, on est amené, soit pour obtenir des longueurs suffisantes, soit par nécessité expérimentale, à effectuer des liaisons entre fils supraconducteurs. Or ce contact entre les fils supraconducteurs qui sont constitués classiquement d'une matrice métallique, par exemple en bronze ou en cuivre, enfermant au moins un brin ou filament supraconducteur (en alliages ou mélanges métalliques tels que le niobium-titane ou le niobium-étain) introduit une résistance électrique non négligeable dans le circuit et hypothèque par conséquent l'intérêt des fils supraconducteurs.

Pour essayer d'obtenir une résistance de contact très faible entre fils supraconducteurs on a déjà envisagé de souder ces fils en soumettant les brins ou filaments de ce fil à un bombardement ionique pour leur nettoyage, puis en pulvérisant un matériau d'apport extrait d'une cible également soumise à un bombardement ionique, ce qui fournit une couche de soudure reliant les deux fils. Un tel procédé est décrit dans le brevet français 77 21 671.

Un tel procédé présente l'inconvénient que la résistance de contact résiduelle établie entre les deux fils soudés est encore relativement grande, de l'ordre de $10^{-8}$ ohm. Une résistance aussi élevée limite par conséquent l'utilisation d'une bobine supraconductrice en mode permanent. Un autre inconvénient entraîné par le procédé précité est qu'il exige, pour sa mise en œuvre, une installation de bombardement ionique complexe et onéreuse.

Les brevets GB-A-1 073 207 et US-A-3 422 529 décrivent chacun un procédé pour connecter des fils supraconducteurs dans lequel on tord les fils l'un avec l'autre, on les enferme ainsi tordus l'un sur l'autre dans une enveloppe en un matériau très conducteur et on écrase l'ensemble ainsi formé. Dans ce procédé l'écrasement des fils supraconducteurs et de leur enveloppe est réalisé au moyen d'une presse mécanique.

Un autre procédé connu, tel que décrit dans le brevet Gb-1 298 068 consiste à «souder» à froid les fils en exerçant sur ceux-ci une forte pression mécaniquement ou par une explosion. Un tel procédé présente l'inconvénient d'exiger, pour sa mise en œuvre, l'emploi de moyens peu commodes et de ne pas permettre d'obtenir une très faible résistance de contact résiduelle.

La présente invention vise à remédier à ces inconvénients en procurant un procédé facile à mettre en œuvre et permettant d'obtenir une résistance de contact entre fils supraconducteurs très faible ou pratiquement négligeable.

A cet effet ce procédé pour réaliser une connexion entre fils supraconducteurs constitués d'un ou plusieurs brins ou filaments en matériau supraconducteur noyés dans une matrice métallique, dans lequel on élimine préalablement le métal constituant la matrice sur une certaine longueur de chaque fil, correspondant à la zone de contact désirée entre les fils, de manière à faire apparaître le ou les brins supraconducteurs de ces fils, on met en contact, les uns avec les autres, les brins supraconducteurs apparents des deux fils, on engage les brins dans un tube en matériau à bonne conductivité électrique, et on établit la liaison entre les brins par sertissage à froid de l'ensemble tube-brins supraconducteurs, est caractérisé en ce qu'on applique les brins supraconducteurs sur un support engagé dans le tube, on utilise, en tant que tube, un morceau de feuillard supraconducteur, on place, autour de l'ensemble constitué par le support, les brins supraconducteurs et le morceau de feuillard supraconducteur, une gaine en matériau à bonne conductivité électrique et on soumet ensuite l'ensemble ainsi obtenu à une opération de magnétoformage provoquant un sertissage de la gaine externe sur le support, avec écrasement du feuillard sur les brins supraconducteurs.

De préférence on enroule les brins supraconducteurs apparents des deux fils autour d'un mandrin et on place ensuite, autour de ce mandrin, un fourreau en matériau supraconducteur, ce fourreau étant ensuite entouré par la gaine en matériau à bonne conductivité électrique.

Le procédé suivant l'invention offre l'avantage qu'il est très facile à mettre en œuvre puisqu'il exige simplement l'utilisation d'un appareil de magnétoformage qui permet de localiser la contrainte exercée, à volonté, en tout endroit désiré. En outre, les essais réalisés ont montré que la résistance de contact entre fils conducteurs obtenue par ce procédé est inférieure à $10^{-17}$ ohm et ce sans détérioration des propriétés intrinsèques des fils. Par ailleurs le courant critique du fil supraconducteur n'est pas limité dans le contact ainsi obtenu.

Le procédé suivant l'invention rent être utilisé chaque fois que l'on a à réaliser une liaison entre fils supraconducteurs. Notamment les applications des supraconducteurs, dans lesquelles des courants importants sont mis en jeu (bobines, alternateurs supraconducteurs, quadripoles supraconducteurs, anneaux de stockage supraconducteurs, etc.) imposent de faire appel au procédé suivant l'invention. A titre d'exemple on peut réaliser, grâce au procédé suivant l'invention, des aimants permanents supraconducteurs. Ainsi une bobine produisant 8 teslas et dont la self inductance est de l'ordre de 10 Henrys voit son courant décroître avec une constante de temps $\tau = \dfrac{L}{R}$ égale à $10^{18}$ secondes.

On décrira ci-après, à titre d'exemples non limitatifs, diverses formes d'exécution de la présente invention, en référence au dessin annexé sur lequel:

La figure 1 est un schéma illustrant la mise en œuvre du procédé suivant l'invention permettant de réaliser une connexion entre deux fils supraconducteurs.

La figure 2 est une vue en coupe axiale d'une connexion réalisée entre deux fils conducteurs par la mise en œuvre du procédé suivant l'invention.

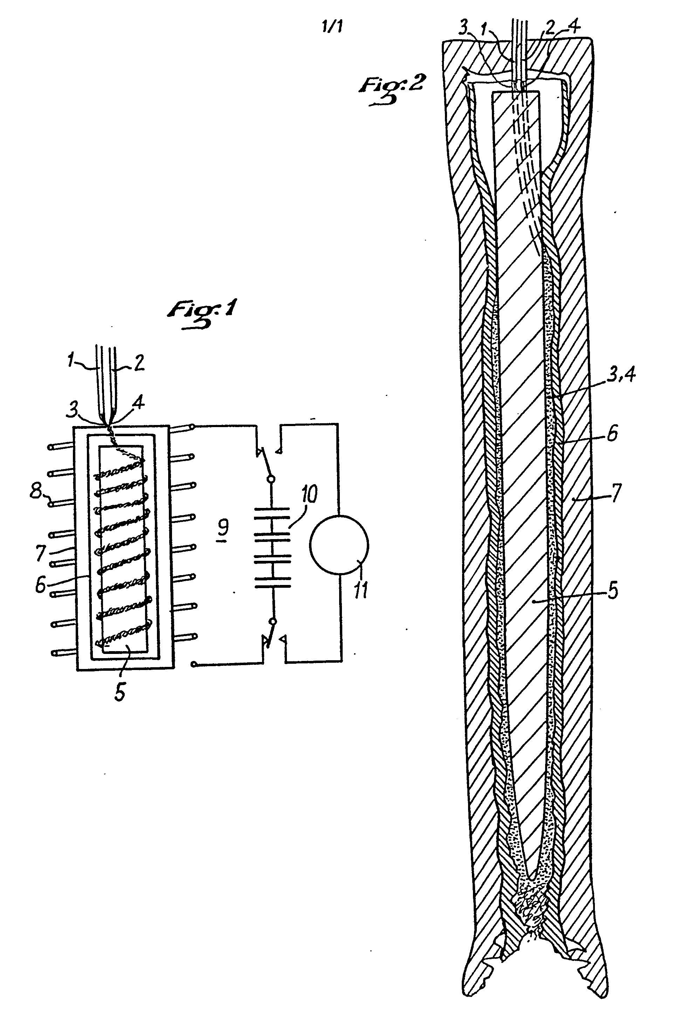

La figure 1 représente deux fils supraconducteurs 1 et 2 qui doivent être connectés l'un à l'autre avec une résistance de contact la plus faible possible. Chacun de ces deux fils comporte, d'une façon connue, une matrice métallique, par exemple en bronze ou cuivre, dans laquelle sont noyés un ou plusieurs brins ou filaments en matériau supraconducteur.

Pour réaliser la connexion entre les deux fils 1 et 2, on élimine tout d'abord le matériau métallique constituant la matrice des fils 1 et 2 de manière à rendre apparents, sur une certaine longueur, les monobrins supraconducteurs de chaque fil indiqué par les références 3 et 4 sur la figure 1. On applique ensuite les brins 3 et 4 ainsi apparents, les uns à proximité des autres, sur un support 5 en matériau supraconducteur ou non. Dans le cas particulier non limitatif qui est illustré sur la figure 1 les monobrins supraconducteurs 3 et 4 sont préalablement torsadés avant d'être enroulés, en spires rapprochées, sur le support 5 constituant un mandrin de section circulaire ou autre.

On entoure ensuite le mandrin 5, sur lequel sont enroulés et appliqués les brins supraconducteurs 3 et 4, un morceau de feuillard 6 en matériau supraconducteur et assez fin, son épaisseur étant de l'ordre de quelques microns. Dans le cas illustré sur la figure 1 le feuillard 6 constitue un fourreau entourant le mandrin 5 et d'un diamètre un peu supérieur au diamètre externe de celui-ci.

On place ensuite l'ensemble formé par le mandrin 5 et les brins supraconducteurs 3 et 4 enroulés sur lui, à l'intérieur une gaine tubulaire externe 7 en un matériau à bonne conductivité électrique, par exemple en cuivre. Cette gaine tubulaire 7 a un diamètre légèrement supérieur à celui du fourreau supraconducteur 6 et une épaisseur de l'ordre d'un mm. La gaine tubulaire externe 7 a une longueur égale ou légèrement supérieure à celle du fourreau 6 et du mandrin 5.

On soumet ensuite l'ensemble obtenu précédemment à une opération de magnétoformage. Pour ce faire on place l'ensemble 5, 6, 7 dans un solénoïde 8 d'un appareil de magnétoformage 9 comportant, de la manière conventionnelle, une batterie de condensateurs 10 devant être chargés par une source de courant continu 11 et déchargés à travers le solénoïde 8. La décharge de la batterie de condensateur 10 se traduit par la libération d'une énergie très élevée en un temps très court (par exemple 10 kilojoules en quelques microsecondes) et cette énergie se traduit par la production d'un champ magnétique très intense dans le solénoïde 8. Ce champ magnétique provoque à son tour un rétreint transversal de la gaine externe 7 conductrice de l'électricité, autrement dit un sertissage de cette gaine 7 sur le mandrin interne 5. La gaine 7 se trouve ainsi écrasée et elle écrase à son tour le fourreau supraconducteur intermédiaire 6 sur les brins supraconducteurs 3 et 4 maintenus par le mandrin central 5.

La figure 2 montre la connexion qui est ainsi obtenue en mettant en œuvre le procédé suivant l'invention. On voit que l'ensemble des brins supraconducteurs 3, 4 sont très fortement écrasés entre le mandrin central 5 et le fourreau supraconducteur 6.

Du fait du contact intime entre les brins supraconducteurs 3, 4 et entre ces brins et le fourreau supraconducteur 6 qui les englobe, on obtient une résistance de contact très faible, qui, d'après les essais effectués, est inférieure à $10^{-17}$ ohm.

On voit d'après la description qui précède que le procédé suivant l'invention est très facile à mettre en œuvre puisqu'il fait appel uniquement à un appareil de magnétoformage dont la conception est remarquablement simple.

## Revendications

1. Procédé pour réaliser une connexion entre fils supraconducteurs constitués d'un ou plusieurs brins ou filaments en matériau supraconducteur noyés dans une matrice métallique, dans lequel on élimine préalablement le métal constituant la matrice sur une certaine longueur de chaque fil (1, 2), correspondant à la zone de contact désirée entre les fils, de manière à faire apparaître le ou les brins supraconducteurs (3, 4) de ces fils, on met en contact, les uns avec les autres, les brins supraconducteurs apparents des deux fils, on engage les brins (3, 4) dans un tube (6) en matériau à bonne conductivité électrique, et on établit la liaison entre les brins (3, 4) par sertissage à froid de l'ensemble tube-brins supraconducteurs (3, 4), caractérisé en ce qu'on applique les brins supraconducteurs (3, 4) sur un support (5) engagé dans le tube (6), on utilise, en tant que tube (6), un morceau de feuillard supraconducteur (6), on place, autour de l'ensemble constitué par le support (5) les brins supraconducteurs (3, 4) et le morceau de feuillard supraconducteur (6), une gaine (7) en matériau à bonne conductivité électrique et on soumet ensuite l'ensemble ainsi obtenu à une opération de magnétoformage provoquant un sertissage de la gaine externe (7) sur le support (5), avec écrasement du feuillard (6) sur les brins supraconducteurs (3, 4).

2. Procédé suivant la revendication 1 caractérisé en ce qu'on enroule les brins supraconducteurs apparents (3, 4) des deux fils autour d'un mandrin (5) et on place ensuite, autour de ce mandrin, un fourreau (6) en matériau supraconducteur qui est ensuite entouré par la gaine (7) en matériau à bonne conductivité électrique.

## Patentansprüche

1. Verfahren zur Herstellung einer Verbindung zwischen supraleitenden Drähten, die aus einer oder mehreren Adern aus supraleitendem Material bestehen, die in eine metallische Matrix eingebettet sind, wobei das die Matrix bildende Metall vorher über eine gewisse Länge eines jeden Drahtes (1, 2) entsprechend der gewünschten Kontaktzone zwischen den Drähten entfernt worden ist, um die oder jede supraleitende Ader (3, 4) dieser Drähte freizulegen, wobei man die freigelegten Adern der beiden Drähte miteinander in Kontakt bringt, die Adern (3, 4) in ein Rohr (6) aus einem Material mit guter elektrischer Leitfähigkeit einführt und eine Verbindung zwischen den Adern (3, 4) durch Kaltverpressen der aus dem Rohr und den supraleitenden Adern (3, 4) bestehenden Anordnung herstellt, dadurch gekennzeichnet, dass man die supraleitenden Adern (3, 4) auf einen in das Rohr (6) eingesetzten Träger (5) aufbringt, wobei als Rohr (6) ein Stück aus einem supraleitenden Bandmaterial verwendet wird, dass man um die aus dem Träger (5), den supraleitenden Adern (3, 4) und dem supraleitenden Bandmaterial (6) gebildete Anordnung eine Hülle (7) aus einem Material mit guter elektrischer Leitfähigkeit legt und anschliessend die so erhaltene Anordnung einer magnetischen Verformung unterwirft, die eine Quetschverbindung der äusseren Hülle (7) mit dem Träger (5) mit einer Zerquetschung des bandförmigen Materials (6) auf den supraleitenden Adern (3, 4) bewirkt.

2. Verfahren nach Anspruch 1, dadurch gekennzeichnet, dass man die freigelegten supraleitenden Adern (3, 4) der beiden Drähte um einen Dorn (5) wickelt und anschliessend um den Dorn eine Hülse (6) aus supraleitendem Material legt, die dann von der Hülle (7) aus elektrisch gut leitendem Material umgeben wird.

## Claims

1. Process for making a connection between superconductive wires constituted by one or more strands or filaments of superconductive material embedded in a metallic matrix, in which the metal constituting the matrix is previously eliminated over a certain length of each wire (1, 2), corresponding to the desired zone of contact between the wires, so as to expose the or each superconductive strand (3, 4) of these wires, the exposed superconductive strands of the two wires are put into contact together, the strands (3, 4) are introduced in a tube (6) of a material which is a good conductor of electricity, and the linkage is established between the strands (3, 4) by exerting a strong pressure, cold, on the superconductive strands (3, 4) – tube assembly, characterized in that it further comprises the steps wherein the superconductive strands (3, 4) are applied on a support (5) introduced in the tube (6), a strip of superconductive material (6) is used as tube (6), a sheath (7) made of a material which is a good conductor of electricity is placed around the assembly constituted by the support (5), the superconductive strands (3, 4) and the superconductive strip (6) and the assembly thus obtained is then subjected to a magnetoforming operation provoking crimping of the outer sheath (7) on the support (5), with crushing of the superconductive strip (6) on the superconductive strands (3, 4).

2. A process according to claim 1, characterized in that the exposed superconductive strands (3, 4) of the two wires are wound around a mandrel (5) and a sleeve (6) of superconductive material is then placed around this mandrel, this sleeve then being surrounded by the sheath (7) of electrically conducting material.

*Fig.1*

*Fig.2*